# EUROPEAN PATENT APPLICATION

(11) **EP 2 301 709 A1**
(43) Date of publication of application: **30.03.2011**
(21) Application number: 08876579.7
(22) Date of filing: 12.12.2008
(51) Int. Cl.: B23P 15/32, B23B 51/00, B23B 51/06

(54) **DRILL HEAD MANUFACTURING METHOD, AND DRILL HEAD**

(30) Priority: 16.07.2008 JP 2008184844
(71) Applicant: UNITAC, Incorporated, Amagasaki-shi, Hyogo 661-0033 (JP)
(72) Inventor: NOMURA, Takuji, Amagasaki-shi Hyogo 661-0033 (JP)
(74) Representative: Vossius & Partner
(86) International application number: PCT/JP2008/072630
(87) International publication number: WO 2010/007700

(57) **Abstract**

Provided is a drill head manufacturing method in which a CVD coating is applied in manufacturing of a drill head where conventionally only a PVDcoating is applicable, thereby utilizing features of the CVD method effectively, which renders a tool service life longer and enables a drill head more suitable for high-speed cutting to be manufactured. A cutting tip 2 having been CVD coated with a hard material is brazed to a required portion at a distal end side of a head main body 1. An outer diameter portion OD of the brazed tip 2 about a rotation axis G of the head main body 1 is polished. Then, the cutting tip 2 and the head main body are PVD coated with a hard material at a temperature lower than the brazing temperature.

## Description

### [Technical Field]

The present invention relates to a manufacturing method of a drill head used for drilling a metal workpiece. The present invention further relates to a drill head manufactured by the method.

### [Background Art]

In manufacturing a drill head, conventionally, first, a cutting tip and a guide pad are silver brazed to required portions at a distal end side of a head main body. Then, outer diameter portions of the brazed cutting tip and guide pad about a rotation axis of the head main body are polished to remove partial protrusions of the outer diameter portions and adjust an outer diameter of the drill head. Lastly, a coating over the entire the cutting tip, the guide pad and the head main body is applied.

The aforementioned coating forms a film with a thickness of 3 to 16 µm in a single layer or multiple layers on surfaces of the tip, the guide pad and the head main body by using a hard material such as titanium carbide and titanium nitride. The purpose thereof is to extend a tool service life, in particular, a tip service life. There are two types of this coating, a CVD coating and a PVD coating.

The CVD coating is a chemical vapor deposition method of evaporating a hard material onto a surface of a base material by chemical reaction of gases at a high temperature of 900 to 1100 degrees C. Adhesion strength thereof to the base material is remarkably high, and a coating layer has abrasion resistance, heat resistance, oxidation resistance and chemical reaction resistance superior to cemented carbide. As a result, a tool applied with the CVD coating has a long service life and further is suitable for high-speed cutting. On the other hand, the PVD coating is a physical vapor deposition method of ionizing, reacting and evaporating an evaporation material at a relatively low temperature of 300 to 800 degrees C by using electrical energy. Although adhesion between the film and the base material is inferior to that of the CVD method, a coating to an acute portion which is considered difficult in the CVD method is possible. The PVD coating is suitable for coating a blade point portion of the tip.

On the other hand, a coating performed at the end of the process in a conventional drill head manufacturing is the PVD coating which is a so-called low-temperature coating. That is, the conventional coating is provided after the cutting tip and the guide pad are silver brazed to the head main body and outer diameter portions of the brazed tip and guide pad are polished. Since the brazing temperature is 400 to 800 degrees C, a coating at a temperature higher than the brazing temperature moves or detaches the brazed portions, therefore, the PVD coating which is processed at a temperature lower than the brazing temperature is applied.

### [Disclosure of the Invention]

### [Problems to be Solved by the Invention]

Accordingly, an obj ect of the present invention is to provide a drill head manufacturing method in which the CVD coating is also applied in manufacturing of a drill he ad where conventionally only the PVD coating is applicable as described above, thereby utilizing features of the CVD method effectively, which renders a tip service life longer and enables a drill head more suitable for high-speed cutting to be manufactured. Another object of the present invention is to provide a drill head manufactured by this method.

### [Means for Solving the Problems]

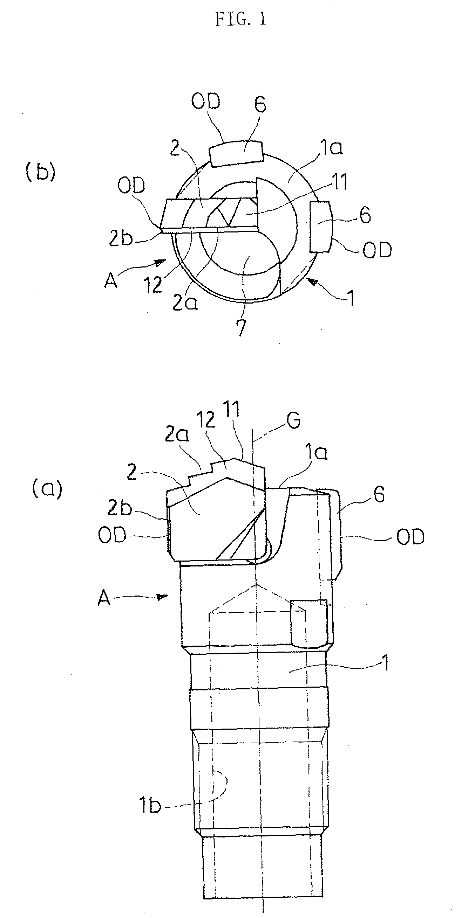

Means for solving the aforementioned problems will be described with reference symbols of an embodiment as shown in FIG. 1 which will be described later. A drill head manufacturing method according to a first aspect of the present invention comprises the steps of CVD coating a cutting tip 2 with a hard material, brazing the CVD coated cutting tip 2 to a required portion at a distal end side of a head main body 1, polishing an outer diameter portion OD of the brazed tip 2 about a rotation axis G of the head main body 1, and then PVD coating the cutting tip 2 and the head main body 1 with a hard material at a temperature lower than a brazing temperature.

A second aspect is configured such that the hard materials used for respective CVD and PVD coatings are titanium carbide, titanium nitride, titanium carbonitride and/or alumina in the drill head manufacturing method as described in the first aspect.

A drill head according to a third aspect of the present invention comprises a cutting tip 2 CVD coated beforehand with a hard material, a head main body 1 having a required portion at a distal end side thereof brazed with the CVD coated cutting tip 2, an outer diameter portion OD of the brazed tip 2 about a rotation axis G of the head main body 1, the outer diameter portion OD being polished, and the cutting tip 2 and the head main body 1 then PVD coated with a hard material.

A fourth aspect is configured such that the hard materials used for respective CVD and PVD coatings are titanium carbide, titanium nitride, titanium carbonitride and/or alumina in the drill head as described in the third aspect.

### [Effects of the Invention]

Effects of the solving means of the present invention will be described with reference symbols of the embodiment as shown in FIG. 1. The drill head manufacturing method according to the first aspect of the present invention comprises the steps of CVD coating a cutting tip 2 under a high temperature, for example, about 1000 degrees C, brazing the CVD coated cutting tip 2 to a required portion at a distal end side of a head main body 1 at, for example, about 600 degrees C in advance, polishing an outer diameter portion OD of the brazed tip 2 about a rotation axis G of the head main body 1, and then PVD coating the cutting tip 2 and the head main body 1 at a temperature lower than the brazing temperature, for example, about 500 degrees C. Even if a CVD coating layer having been formed on a surface of the cutting tip 2 by the CVD coating is chipped off of a blade point portion 2b at an outer circumferential side by polishing the outer diameter portion OD, the CVD coating layer is left as is on a region other than this outer diameter portion OD, in particular, on a blade point portion 2a at a distal end side. Therefore, the blade point portion 2a at the distal end side can exert characteristics of the CVD coating layer. That is, the characteristics of the CVD coating layer are that adhesion strength between the layer and a base material is remarkably high and the CVD coating layer has abrasion resistance and heat resistance superior to cemented carbide. Thus, the CVD coating layer having been formed on the blade point portion 2a at the distal end side of the cutting tip 2 improves abrasion resistance and heat resistance of the blade point portion 2a significantly, which leads to a longer service life of the cutting tip 2 and renders the cutting tip 2 suitable particularly for high-speed cutting.

Further, even if the CVD coating layer having been formed on the blade point portion 2b at the outer circumferential side of the outer diameter portion OD of the cutting tip 2 about the rotation axis G of the head main body 1 is lost due to the polishing of the outer diameter portion OD, a PVD coating layer is formed on this blade point portion 2b at the outer circumferential side by the PVD coating after the polishing. Thus, abrasion resistance and heat resistance of the blade point portion 2b at the outer circumferential side are also ensured, thereby extending its service life, and accordingly the service life of the cutting tip 2 can be rendered longer. Since the PVD coating processing temperature is lower than the brazing temperature, the brazed portion cannot be melted and moved or detached by the PVD coating after the brazing. Further, a coating to an acute portion which is considered relatively difficult in the CVD coating becomes possible by the PVD coating. Blade point edges of the blade point portions 2a and 2b can be coated sufficiently.

As described in the second aspect, the hard materials used for respective CVD and PVD coatings are titanium carbide, titanium nitride, titanium carbonitride and/or alumina in the drill head manufacturing method as described in the first aspect.

The drill head according to the third aspect of the present invention is formed by the method as set forth in the first aspect. The cutting tip 2 having been CVD coated in advance is brazed to a required portion at the distal end side of the head main body 1. An outer diameter portion OD of the brazed tip 2 about the rotation axis G of the head main body 1 is polished, and then the cutting tip 2 and the head main body 1 are PVD coated at a temperature lower than the brazing temperature. Thus, the cutting tip 2 has a longer service life and becomes suitable especially for high-speed cutting.

As described in the fourth aspect, the hard materials used for respective CVD and PVD coatings are titanium carbide, titanium nitride, titanium carbonitride and/or alumina in the drill head as described in the third aspect.

### [Brief Description of the Drawings]

FIG. 1 (a) is a front view showing a drill head manufactured by a method according to the present invention and FIG. 1 (b) is a plan view thereof;
FIG. 2 (a) is a front view showing another drill head manufactured by the method according to the present invention and FIG. 2(b) is a plan view thereof.

### [Description of Symbols]

- A, B:: Drill head
- 1:: Head main body
- 2, 3, 4, 5:: Cutting tip
- 6:: Guide pad
- OD:: Outer diameter portion
- G:: Rotation axis of head main body

### [Best Modes for Carrying Out the Invention]

Preferred embodiments of the present invention will be described with reference to the drawings. FIG. 1 (a) is a front view showing a drill head manufactured by a method according to the present invention, and FIG. 1 (b) is a plan view thereof. The drill head A has a substantially cylindrical head main body 1. The head main body 1 has a distal end side surface 1a brazed with a piece of cutting tip 2 radially from a rotation axis G thereof. The cutting tip 2 has blade point portions 2a and 2b at a distal end side and an outer circumferential side. Moreover, guide pads 6 are brazed to required portions on side surfaces of the head main body 1 in the same manner as the cutting tip 2. Reference numeral 7 denotes a chip discharge port communicated with a hollow portion 1b of the head main body 1 in FIG. 1.

Subsequently, a manufacturing method of the drill head A will be described.

First, the cutting tip 2 is CVD coated with a hard material. The CVD coated cutting tip 2 is silver brazed to a required portion at the distal end side of the head main body 1. The guide pad 6 is silver brazed to a required portion on the side surface of the head main body 1. Then, outer diameter portions OD of the brazed cutting tip 2 and guide pad 6 about the rotation axis G of the head main body 1 are polished, thereby adjusting an outer diameter of the drill head A including the cutting tip 2 and the guide pad 6. After that, the cutting tip 2, the guide pad 6 and the head main body 1 are all PVD coated with a hard material at a temperature lower than the brazing temperature.

In this manufacturing method, cemented carbide is used for the cutting tip 2, and for the CVD coating of the tip 2, titanium carbide, titanium nitride, titanium carbonitride and/or alumina are used as the hard material. Then, a film of titanium carbide, titanium nitride, titanium carbonitride and/or alumina, that is, a CVD coating layer is formed on a surface of the cutting tip 2 in a single layer (or multiple layers) with a film thickness of, for example, about 6 to 8 µm by a chemical vapor deposition (CVD) method under a high temperature, for example, 1000 degrees C. This CVD coating layer has abrasion resistance, heat resistance, oxidation resistance and chemical reaction resistance superior to cemented carbide.

In this case, the single CVD coating layer is composed of any one desired layer of titanium carbide, titanium nitride, titanium carbonitride or alumina, and the multiple CVD coating layers are composed of any plural layers among titanium carbide, titanium nitride, titanium carbonitride and alumina or layers of all of them.

A brazing temperature of the cutting tip 2 and the guide pad 6 to the head main body 1 is about 600 degrees C, for example.

Polished amounts of the outer diameter portions OD of the cutting tip 2 and the guide pad 6 about the rotation axis G of the head main body 1 are in some cases smaller than the film thickness of the CVD coating layer, and in other cases larger than that. Accordingly, when the polished amounts are smaller than the film thickness, the CVD coating layer is left. When the polished amounts exceed the film thickness, the CVD coating layer on the blade point portion 2b at the outer circumferential side of the cutting tip 2 is removed and is not left.

Further, titanium carbide, titanium nitride, titanium carbonitride and/or alumina are used as the hard material in the PVD coating performed after the polishing of the outer diameter portions OD. Then, a film of titanium carbide, titanium nitride, titanium carbonitride and/or alumina, that is, a PVD coating layer is formed on surfaces of the polished cutting tip 2, guide pad 6 and head main body 1 in a single layer (or multiple layers) with a film thickness of, for example, about 3 to 5 µm by a physical vapor deposition (PVD) method at, for example, about 500 degrees C lower than the aforementioned brazing temperature, about 600 degrees C, of the cutting tip 2 and guide pad 6. The PVD coating is able to coat an acute portion, which is considered difficult in the CVD method, and is suitable for a coating to the blade point portion of the tip. Therefore, coating layers are accurately formed on acute portions of the blade point portions 2a and 2b of the cutting tip 2 as well.

In this case, the single PVD coating layer is composed of any one desired layer of titanium carbide, titanium nitride, titanium carbonitride or alumina, and the multiple PVD coating layers are composed of any plural layers among titanium carbide, titanium nitride, titanium carbonitride and alumina or layers of all of them.

According to the foregoing manufacturing method of the drill head A, the cutting tip 2 having been CVD coated with a hard material under a high temperature, for example, about 1000 degrees C is brazed to a required portion at the distal end side of the head main body 1 at, for example, about 600 degrees C. The outer diameter portion OD of the brazed tip 2 about the rotation axis G of the head main body 1 is polished, and then, the cutting tip 2, the guide pad 6 and the head main body 1 are PVD coated with a hard material at a temperature lower than the brazing temperature, for example, about 500 degrees C. Therefore, even if the CVD coating layer having been formed on the surface of the cutting tip 2 by the CVD coating is chipped off of the blade point portion 2b at the outer circumferential side by the polishing of the outer diameter portion OD, the CVD coating layer is left as is on a region other than this outer diameter portion OD, especially on the blade point portion 2a at the distal end side. Thus, the blade point portion 2a at the distal end side can exert characteristics of the CVD coating layer. That is, the characteristics of the CVD coating layer are that adhesion strength between the layer and a base material is remarkably high and the CVD coating layer has abrasion resistance and heat resistance superior to cemented carbide. Thus, the CVD coating layer having been formed on the blade point portion 2a at the distal end side of the cutting tip 2 significantly improves abrasion resistance and heat resistance of a flank face 11 and a cutting face 12 in the blade point portion 2a at the distal end side. This renders the service life of the cutting tip 2 longer and the cutting tip 2 suitable particularly for high-speed cutting.

Further, even if the CVD coating layer having been formed on the blade point portion 2b at the outer circumferential side of the outer diameter portion OD of the cutting tip 2 about the rotation axis G of the head main body 1 is lost due to the polishing of the outer diameter portion OD, a PVD coating layer is formed on this blade point portion 2b at the outer circumferential side by the PVD coating after the polishing. Thus, abrasion resistance and heat resistance of the blade point portion 2b at the outer circumferential side is also secured, and the service life thereof is extended. Accordingly, the service life of the cutting tip 2 can be extended. In addition, since the PVD coating processing temperature is lower than the brazing temperature, the brazed portion cannot be melted and moved or detached by the PVD coating after the brazing. Further, a coating to an acute portion which is considered relatively difficult in the CVD coating becomes possible by the PVD coating, and thus, a blade point edge of the blade point portion 2a at the distal end side and a blade point edge of the blade point portion 2b at the outer circumferential side can be coated sufficiently.

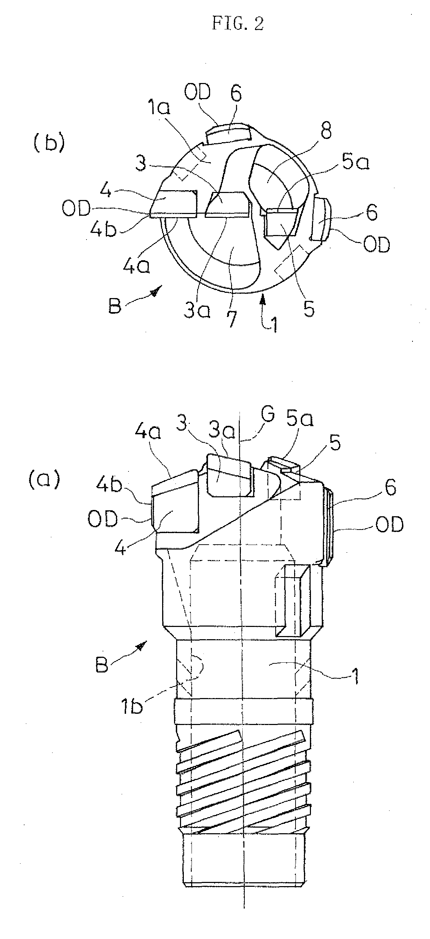

FIG. 2 (a) is a front view showing another drill head manufactured by the method according to the present invention, and FIG. 2(b) is a plan view thereof. The drill head B has a substantially cylindrical head main body 1. The head main body 1 has a distal end side surface la formed with a large and a small chip discharge port 7 and 8 communicated with a hollow portion 1b and opposed to each other in a diameter direction. A central cutting tip 3 and a circumferential cutting tip 4 are brazed to an opening side edge of the large chip discharge port 7 along a radial direction of the head main body 1, and an intermediate cutting tip 5 is brazed to an opening side edge of the small chip discharge port 8 along the radial direction of the head main body 1, respectively. Further, guide pads 6 are brazed to required portions on side surfaces of the head main body 1.

A manufacturing method of the drill head B will be briefly described. First, the central, circumferential and intermediate cutting tips 3 to 5 are CVD coated with a hard material. Then the CVD coated cutting tips 3 to 5 are silver brazed to required portions at the distal end side of the head main body 1. Also, the guide pad 6 is silver brazed to a required portion on a side surface of the head main body 1. Then, outer diameter portions OD of the silver brazed circumferential cutting tip 4 and guide pad 6 about the rotation axis G of the head main body 1 are polished to adjust an outer diameter of the drill head B including the circumferential cutting tip 4 and the guide pad 6. After that, the whole of the central, circumferential and intermediate cutting tips 3 to 5, guide pad 6, and the head main body 1 is PVD coated with a hard material at a temperature lower than the brazing temperature. In this case, the CVD coating temperature is about 1000 degrees C, the brazing temperature is about 600 degrees C and the PVD coating temperature is about 500 degrees C, which are the same for the drill head A.

In the manufacturing method of the drill head B, cemented carbide is used for the cutting tips 3 to 5. For the CVD and PVD coatings of the tips 3 to 5, titanium carbide, titanium nitride, titanium carbonitride and/or alumina are used as the hard material in the same manner as the drill head A.

The foregoing manufacturing method of the drill head B comprises brazing the CVD coated three central, circumferential and intermediate cutting tips 3 to 5 to required portions at the distal end side of the head main body 1, polishing outer diameter portions OD of the circumferential cutting tip 4 and guide pad 6 about the rotation axis G of the head main body 1, and then, PVD coating the cutting tips 3 to 5, the guide pad 6 and the head main body 1 at a temperature lower than the brazing temperature. CVD coating layers are formed on respective surfaces of three of the central, circumferential and intermediate cutting tips 3 to 5 by the CVD coating. Thus, the CVD coating layers of the central and intermediate cutting tips 3 and 5 are left as they are. Even if the CVD coating layer on a blade point portion 4b at the outer circumferential side of the circumferential cutting tip 4 is chipped off and is not left due to the polishing of the outer diameter portion OD thereof, the CVD coating layer is left on a region other than the outer diameter portion OD, particularly on a blade point portion 4a at the distal end side. Thus, characteristics of the CVD coating layer can be exerted, whereby abrasion resistance and heat resistance of the blade point portion 4a at the distal end side and a flank face and a cutting face thereof are significantly improved, and accordingly, the service life of the circumferential cutting tip 4 is extended. The central and intermediate cutting tips 3 and 5, in particular, blade point portions 3a and 5a at the distal end side and flank faces and cutting faces thereof can sufficiently exert the characteristics of the CVD coating layer, respectively. The cutting tips 3 and 5 result in having longer service lives. Accordingly, the drill head B itself has a longer service life and becomes optimum for high-speed cutting.

Further, even when the CVD coating layer is not left on the blade point portion 4b at the outer circumferential side of the outer diameter portion OD of the circumferential cutting tip 4 about the rotation axis G of the head main body 1, a PVD coating layer is formed on this blade point portion 4b at the circumferential side by the PVD coating after the polishing. Consequently, the service life of the blade point portion 4b at the outer circumferential side can be extended, which leads to a longer life of the circumferential cutting tip 4. Further, the guide pad 6 is also PVD coated and formed with a PVD coating layer, and thus, abrasion resistance and heat resistance of outer circumferential surfaces thereof are improved and the service life thereof can be extended.

## Claims

1. A drill head manufacturing method comprising the steps of:
CVD coating a cutting tip with a hard material;
brazing the CVD coated cutting tip to a required portion at a distal end side of a head main body;
polishing an outer diameter portion of the brazed tip about a rotation axis of the head main body; and then
PVD coating the cutting tip and the head main body with a hard material at a temperature lower than a brazing temperature.

2. The drill head manufacturing method according to claim 1, wherein the hard materials used for respective CVD and PVD coatings are titanium carbide, titanium nitride, titanium carbonitride and/or alumina.

3. A drill head comprising:
a cutting tip CVD coated with a hard material;
a head main body having a required portion at a distal end side thereof brazed with the CVD coated cutting tip;
an outer diameter portion of the brazed tip about a rotation axis of the head main body, the outer diameter portion being polished; and
the cutting tip and the head main body then PVD coated with a hard material at a temperature lower than a brazing temperature.

4. The drill head according to claim 3, wherein the hard materials used for respective CVD and PVD coatings are titanium carbide, titanium nitride, titanium carbonitride and/or alumina.
